# EUROPEAN PATENT SPECIFICATION

(11) **EP 3 183 534 B1**
(45) Date of publication and mention of the grant of the patent: **07.11.2018**
(21) Application number: 15753793.7
(22) Date of filing: 23.07.2015
(51) Int. Cl.: G06T 7/60, G06F 17/50, G06T 7/521, G01B 11/25, B66B 9/08, E04F 21/26, G01B 11/00

(54) **METHOD AND SYSTEM FOR DESIGNING A STAIR LIFT RAIL ASSEMBLY**
VERFAHREN UND SYSTEM ZUM ENTWERFEN EINER TREPPENLIFTSCHIENENANORDNUNG
PROCÉDÉ ET SYSTÈME DE CONCEPTION D'UN ENSEMBLE RAIL DE MONTE-ESCALIER

(30) Priority: 22.08.2014 NL 2013355
(43) Date of publication of application: 28.06.2017
(73) Proprietor: Handicare Stairlifts B.V., 1704 SB Heerhugowaard (NL)
(72) Inventor: NUIJTEN, Johannes Maria Antonius, NL-2032 LM Haarlem (NL)
(74) Representative: EP&C
(86) International application number: PCT/NL2015/050541
(87) International publication number: WO 2016/028146

(56) References cited:
- EP-A1- 2 085 536
- WO-A1-2013/137733
- KR-A- 20100 128 919
- US-A- 6 082 019
- US-A1- 2012 038 986

## Description

### FIELD OF THE INVENTION

The invention relates to the field of stair lifts, and more specifically to a method and system for designing a rail assembly of a stair lift, on which rail assembly a carrier can be moved to convey a person along a staircase.

### BACKGROUND OF THE INVENTION

When a stair lift is to be designed for implementation at a particular staircase, a first step to take is to acquire an accurate three-dimensional representation of the staircase and its environment to identify interfaces on which to mount a guide, i.e. a rail assembly to support a movable carrier, of the stair lift. To acquire the three-dimensional representation of the staircase and its environment (floor(s), wall(s), ceiling(s), railing(s)), which can be regarded as a three-dimensional structure, a measuring person places a plurality of markers on or at the staircase, such as on steps of the staircase, wherein the markers each are optically identifiable, such as individually optically identifiable. Then, a series of images is taken by a camera, each image showing at least a part of the staircase and the corresponding optical markers. Next, the images are used to generate a three-dimensional representation of the staircase, e.g. in a computer aided design program, using the structural and dimensional information in the images provided by the markers showing therein.

As an example, in the use of markers in the design of a stair lift for use in a particular stairs environment, several computer-implemented measuring and design tools have been developed. Reference WO 2013/137733 A1 discloses a computer-implemented method for the extraction of information about one or more spatial objects by a person. A computer program is designed for real-time analyzing a sequence of images taken by a camera, using image analysis techniques, and extracting information about said one or more objects, and communicating at least part of said information to the person in real time via an output means. The information about said one or more objects comprises at least the spatial position of said one or more objects, the spatial distance between two objects, the spatial relative angle between two essentially linear objects and/or an indication regarding the realized accuracy of the extracted information. Before taking the images by the camera, markers are placed on or near said one or more objects, which e.g. are steps of a staircase. The markers have a shape such that they can take up a detectable spatial orientation in the images. The computer program is designed to determine the spatial position and orientation of the markers on the basis of the markers detected in the images and/or of prominent elements detected in the images, and to use the information of the thus determined position and orientation of the markers during the recording of each of the images upon extracting the aforesaid information about said one or more objects. The computer program may be designed for calculating dimensions of parts of a guide of a stair lift to be installed at said staircase.

Although in the process of designing and producing a stair lift several efficiency enhancing steps have been developed over time, the first step of measuring an actual staircase using markers disadvantageously consumes relatively much time, and thus induces relatively high costs. This is due to the required accurate and selective positioning of a plurality of optical markers by hand, and carefully choosing positions for taking images which together need to clearly and completely show all markers, and their relative positions. Since this positioning is a process performed by a person, it is prone to errors, such as mislaying specific markers, or omitting relevant markers.

After taking the images, the markers need to be collected and stored again by hand in an orderly manner. Further disadvantages of the use of optical markers are that they may become soiled, damaged or lost, rendering a set of markers unfit for use. This may lead to incomplete measurements, or postponement of measurement, awaiting replacement markers.

KR 2010/0128919 A discloses a system and a method for measuring stair dimensions using a single camera and a laser to accurately analyze the dimensions of a stair by obtaining a stair background image and a laser projection image. The system comprises a camera unit, a laser unit, a control unit, an image processing unit, a calculation unit and a storage unit. The camera unit photographs the outer shape of stairs. The laser unit projects a laser on the stairs. The control unit controls the operation of the camera unit and the laser unit. The image processing unit processes the photographed image and transfers the photographed image to the control unit. The calculation unit analyzes and calculates position information of the projected laser. The storage unit stores the calculated stair data and the photographed image.

WO 2013/137733 A1 discloses a computer program for the extraction of information about one or more spatial objects by a person, which program is designed for analyzing the sequence of images in real time, using image analysis techniques, and extracting information about said one or more objects, and communicating at least part of said information to the person in real time via the output means. The information about said one or more objects comprises at least: the spatial position of said one or more objects; the spatial distance between two objects; the spatial relative angle between two essentially linear objects; and/or an indication regarding the realized accuracy of the extracted information.

US 2012/038986 A1 discloses a pattern projector, comprising a light source, configured to emit a beam of light. A transparent substrate, which has a pair of mutually-opposed planar surfaces is configured to receive and propagate the beam within the substrate by total internal reflection between the planar surfaces. The transparent substrate comprises a diffractive structure that is formed on one of the planar surfaces and is configured to direct at least a part of the beam to propagate out of the substrate in a direction that is angled away from the surface and to create a pattern comprising multiple interleaved light and dark areas.

EP 2085536 A1 discloses a measuring device for determining a stair profile. The device has a inclinable ruler with an end mounted pivotingly on a horizontal axis of a bracket connected to a lower support cornice, and another opposite end to be slid in a shoe of an articulated link mounted on a upper support cornice. An angle indicator displays the inclination angle of the ruler between lower and upper steps of a staircase. Another angle indicator associated with the cornice indicates a positioning angle of the upper step with respect to a vertical plane of an apron piece of the staircase.

US 6082019 A discloses a system for determining the length and angle of stair railings, which system is disclosed in the form of a kit of parts and a method. The system includes a pair of vertically adjustable, simulated post housings to be temporarily positioned at the top and bottom of the stairs, where a first housing includes a pivotally mounted, extendable tape measure and angle scale. When the respective post housings are vertically adjusted to position a slidable base member at the projected height for the railing, the tape measure is then extended to the other post housing. While extended, the railing length and angle ends may be readily determined, and the information therefrom in preparing the railing.

### SUMMARY OF THE INVENTION

It would be desirable to provide an alternative to the use of markers to acquire an accurate three-dimensional representation of the staircase and its environment. It would also be desirable to decrease the time to measure an actual staircase.

To better address one or more of these concerns, in a first aspect of the invention a method of designing a stair lift rail assembly to be mounted on a three-dimensional structure, i.e. a staircase and its environment, is provided. The method comprises the steps of: projecting, from a reference location relative to the structure, a light beam comprising an optical pattern on at least part of the structure; detecting light from said at least part of the structure; generating image data of said at least part of the structure based on said detected light; processing the image data to generate a set of map data of said at least part of the structure, the set of map data representing a three-dimensional map of said at least part of the structure; determining a spatial path of the stair lift rail and locations of support interfaces for the stair lift rail assembly in the three-dimensional map; and generating a design of the stair lift rail assembly based on the spatial path of the stair lift rail and the locations of the support interfaces for the stair lift rail assembly.

The set of map data comprises quantization errors, which may complicate an identification of steps of the stairs and/or a wall adjacent to the stairs and/or a railing structure adjacent to the stairs, and which may complicate determining a location of a support interface. Quantization errors, which may be due to the digitalization processes used in the method and system of the present invention, induce local variations in surface and line properties in the three-dimensional map, showing them to be irregular while in reality such surfaces and lines are flat and straight, respectively. To alleviate this problem, in some embodiments of the method, the step of identifying a series of steps comprises determining a plurality of points associated with a top face of the step in the set of map data, fitting a top plane to the plurality of points associated with the top face, and redefining the top plane as the top face in the set of map data. In some embodiments of the method, the step of identifying a series of steps comprises determining a plurality of points associated with the front face of the step in the set of map data, fitting a front plane to the plurality of points associated with the front face, and redefining the front plane as the front face in the set of map data. In some embodiments of the method, the step of identifying a series of steps comprises determining a plurality of points associated with the nose of the step in the set of map data, fitting a nose line to the plurality of points associated with the nose, and redefining the nose line as the nose in the set of map data. In some embodiments of the method, the step of identifying a wall, floor or ceiling adjacent to the stairs comprises determining a plurality of points associated with the wall, floor or ceiling in the set of map data, fitting one or more geometrical surfaces to the plurality of points associated with the wall, floor or ceiling, and redefining the one or more geometrical surfaces as the wall, floor or ceiling in the set of map data. In some embodiments of the method, the step of identifying a railing structure adjacent to the stairs comprises determining a plurality of points associated with the railing structure in the set of map data, fitting one or more geometrical surfaces to the plurality of points associated with the railing structure, and redefining the one or more geometrical surfaces as the railing structure in the set of map data. In such enhanced set of map data, an accuracy of locating support interfaces on the three-dimensional structure is improved by inclusion of the top plane, the front plane, the nose line, and the one or more geometrical surfaces, respectively.

With a projection of a light beam comprising an optical pattern on at least part of a three-dimensional structure, in particular on at least a surface part of the three-dimensional structure, and detecting light from the at least part of the structure, image data can be generated which comprise depth information for different parts of the image. In fact, distances between the reference location (which may be a spatial location of an image sensor detecting the light from the structure) and imaged parts of the structure can be obtained as depth information. The light may comprise visible light, infrared (IR) light, and ultraviolet (UV) light.

The image data are processed to generate a set of map data of the at least part of the structure, where the set of map data is a point cloud, i.e. a cloud of points located on surfaces of the part of the structure as represented by the detected light. Accordingly, the map data represent a three-dimensional map of said at least part of the structure.

In this three-dimensional map, possible locations of support interfaces for a stair lift rail assembly are determined. A support interface generally is a part of a surface of the structure usable for supporting the stair lift rail assembly, where the stair lift rail assembly usually is supported through a plurality of support interfaces on the structure. E.g., the stair lift rail assembly may be supported on different steps of the stairs, or on different locations of a wall adjacent to the stairs, or on a combination of at least one step of the stairs and at least one wall location adjacent to the stairs. Thus, determining locations of support interfaces includes recognition of objects in the three-dimensional map, in particular recognition of objects that may serve to support parts of the stair lift rail assembly, such as steps of the stairs and/or walls or other objects adjacent to the stairs.

In addition to a determination of support interfaces for the stair lift rail assembly in the three-dimensional map, a spatial path of the stair lift assembly is determined. Such a spatial path may be represented by a line having straight and/or curved sections.

From locations of the support interfaces and the spatial path of the stair lift rail, a design of the stair lift rail assembly is generated. Based on the design, the stair lift rail assembly can be constructed. The stair lift rail assembly comprises a rail along which a carrier is movable and operable (e.g. tiltable and/or rotatable), and further comprises support and mounting structures, such as arms, legs and stanchions, wall supports and mounting flanges, to link the stair lift rail to the support interfaces. A carrier may comprise a chair, a footrest, and/or a platform.

In the above method, which at least partly may be implemented on one or more computers, predefined design rules are used to determine locations of support interfaces, to determine a spatial path of the stair lift rail, and to generate a design of the stair lift rail assembly. These design rules may e.g. prescribe minimum free distances between parts of the stair lift rail assembly and surrounding objects such as steps or walls. Furthermore, the design rules may define, based on input or calculated design parameters, e.g. maximum and minimum curve radii, lengths and other dimensions of parts of the stair lift rail assembly.

In the method of the invention, the use of markers can be prevented or omitted. Rather, an optically patterned light beam is used to extract depth information from a three-dimensional structure, which depth information includes a distance between the reference location and a part of the structure. The depth information allows to create a set of map data representing a three-dimensional map of said part of the structure.

Such a method can be performed in a very brief time, and does not need any preparatory step such as placement of markers. At the actual location of the three-dimensional structure, such as a staircase environment, performing the step of generating image data and the preceding steps would be sufficient to collect all information necessary to design a stair lift rail assembly, wherein other steps could be performed at other places and/or in other time periods. Thus, a time period required for the information collection at the actual location of the three-dimensional structure can be relatively short. Since the use of markers is in fact obviated, any problem of storage, transport, handling and maintenance of the markers is also obviated.

As an example of a method and system for generating a set of map data, WO 2007/043036 A1 discloses a system and method for use in object reconstruction, in particular a technique allowing a real-time and very accurate mapping of three-dimensional, 3-D, objects. 3-D information of any part or a whole of object outer surfaces is acquired from image, range or other sensed data. A projection of a laser random speckle pattern onto an object to be reconstructed, is utilized. A speckle pattern is a field-intensity pattern produced by mutual local interference of partially coherent laser beams. A 3-D map of an object is estimated by examining a relative shift of a laser random (non-periodic) pattern (code). This allows for both the determination of a range from a reference plane and the 3-D mapping of the object. An illuminating unit can include a small coherent light source, a laser, and a pattern generator in the form of a light diffuser which is accommodated in the optical path of laser light and scatters this light in the form of constant, coherent and random speckle pattern onto the object. An imaging unit detects a light response of an illuminated region of the object, and generates image data indicative of the object with the projected speckles pattern and thus indicative of a shift of the pattern in the image of the object relative to a reference image of said pattern. Reference data indicative of a reference image of the speckle pattern are stored, and the image data are processed and analyzed utilizing the reference data for determining correlation between the object and reference images. The disclosure of WO 2007/043036 A1 is included by reference herein.

Other known types of patterns to be included in a light beam for obtaining map data representing a three-dimensional map of a three-dimensional structure include periodic patterns, such as lines, in particular equidistant parallel lines or intersecting lines, shapes like squares and rectangles, in particular having different luminosities, etc..

In some embodiments, the method further comprises: generating a plurality of different sets of map data for different, optionally overlapping, parts of the structure, optionally taken from different reference locations; and correlating the different sets of map data with each other to provide an extended set of map data representing a three-dimensional map of a combination of the different parts of the structure.

In practice, a three-dimensional structure may have dimensions in one or more directions, or shapes, that are such as to prevent the structure from being captured as a whole by projecting a light beam towards it. For example, the transverse extension of the light beam allows projecting it only on part of a three-dimensional structure. As another example, the light beam could be projected on the whole of the three-dimensional structure, but this would require such a large distance between the reference location and the structure that an accuracy of image data and/or map data would be unacceptably low. As still another example, the structure can have different parts that are only visible from different reference locations. In all of these and other cases, it is necessary to generate different sets of map data for different (surface) parts of the structure. The different sets of map data may be produced using the same reference location, or they may be produced using different reference locations. By data-stitching or correlating the different sets of map data with each other, an extended set of map data is provided. The extended set of map data represents a three-dimensional map of a combination of the different parts of the structure. The different (surface) parts of the structure may partly overlap, thereby facilitating the correlation process.

In some embodiments of the method, the step of determining locations of support interfaces for the stair lift rail assembly in the three-dimensional map comprises: identifying, in the three-dimensional map, a series of steps of a stairs and/or at least one wall, floor or ceiling and/or a railing structure adjacent to the stairs; and identifying support interfaces on at least some of the steps and/or the at least one wall, floor or ceiling and/or the railing structure, based on design rules.

A stair lift rail assembly is to support a carrier, such as a chair or platform, to be moved along the stair lift rail for conveying a person from the bottom of the stairs to the top of the stairs, and vice versa. The fixedly arranged stair lift rail assembly is mounted on the steps of the stairs, usually on the top face of some of the steps of the stairs, and/or on a wall or railing structure adjacent to the stairs. For this purpose, the stair lift rail assembly may comprise arms and/or legs extending from the stair lift rail, the arms and/or legs being provided with mounting structures such as wall supports or flanges at their ends facing away from the rail. The mounting structures are to be connected to a support interface on a step, wall or railing structure. A support interface may be a part of a face of a step, wall or railing structure.

Design rules may prescribe where to locate support interfaces, based on e.g. required number of support interfaces, loads and moments to be exerted through the support interfaces, minimum or maximum distances to be kept by parts of the stair lift rail assembly from the steps of the stairs and/or from the wall and/or from a railing structure, free profile of movement on the staircase for the carrier movable on the stair lift rail, etc.. When implemented in computer software, the design rules may automatically identify a number of specific locations in the three-dimensional structure for locating support interfaces.

In some embodiments, the method comprises: displaying a model of the three-dimensional structure on a display; and identifying, by a user, in the model at least one support interface.

The user may be a designer inputting data in a computer system identifying a location of a support interface. For this purpose, an electronic pointer may be digitally moved across a computer display screen by the designer using a suitable input device, to indicate support interface locations on the displayed model of the three-dimensional structure. If the display is a touch-sensitive display, the user may touch the display at a location showing an intended location of a support interface on the model of the three-dimensional structure, in order to define this location as a support interface location in the computer system.

In some embodiments of the method, the step of identifying a series of steps of a stairs comprises identifying at least one of a top face, a front face, and a nose of each step.

The top face of a step can be recognized from its horizontal extensions having a width and a depth, and its width being substantially greater than its depth. The front face of a step can be recognized from its non-horizontal, usually vertical extensions having a width and a height, and its width being substantially greater than its height. Also, the height is within a specific range to ensure a comfortable normal use of the stairs. The nose of a step typically is where a top face and a front face of a step meet. Once each step has been identified, and thus the number and succession of steps has been determined, any support interfaces on the steps can be located.

In some embodiments of the method, the step of identifying a series of steps of a stairs and/or at least one wall adjacent to the stairs and/or a railing structure adjacent to the stairs comprises: analyzing image patches comprising image pixels having image pixel attributes, by measuring similarities of image patches based on said pixel attributes using kernel descriptors. Such analyzing process is e.g. known from Liefeng Bo, Xiaofeng Ren, Dieter Fox. "Depth Kernel Descriptors for Object Recognition", Intelligent Robots and Systems (IROS), 2011 IEEE.

In the method of the invention, image data in fact relate to recorded pixels of an image, each image pixel or group of image pixels having pixel attributes including depth information. As a result, a point cloud is obtained which must be processed to determine (parts of) a three-dimensional structure. Image patches comprising a plurality of image pixels are matched and fitted for this purpose. Kernel descriptors provide a way to associate pixel attributes to patch-level features, and allow generation of rich features from a variety of recognition cues through measuring similarities of image patches.

According to a second aspect of the present invention, a system for designing a stair lift rail assembly to be mounted on a three-dimensional structure is provided. The system comprises: a projector configured for projecting, from a reference location relative to the structure, a light beam comprising an optical pattern on at least part of the structure; a detector configured for detecting light from said at least part of the structure; and one or more processors configured for: generating image data of said at least part of the structure based on said detected light; processing the image data to generate a set of map data of said at least part of the structure, the set of map data representing a three-dimensional map of said at least part of the structure; determining a spatial path of the stair lift rail and locations of support interfaces for the stair lift rail assembly in the three-dimensional map; and generating a design of the stair lift rail assembly based on the spatial path of the stair lift rail and the locations of the support interfaces for the stair lift rail assembly, wherein the one or more processors are configured for determining locations of support interfaces for the stair lift rail assembly in the three-dimensional map by: identifying, in the three-dimensional map, a series of steps of a stairs, comprising: determining a plurality of points of the point cloud associated with a top face of the step in the set of map data, fitting a top plane to the plurality of points associated with the top face, and redefining the top plane as the top face in the set of map data; and/or identifying, in the three-dimensional map, a series of steps of a stairs, comprising determining a plurality of points of the point cloud associated with a front face of the step in the set of map data, fitting a front plane to the plurality of points associated with the front face, and redefining the front plane as the front face in the set of map data; and/or identifying, in the three-dimensional map, a series of steps of a stairs, comprising determining a plurality of points of the point cloud associated with a nose of the step in the set of map data, fitting a nose line to the plurality of points associated with the nose, and redefining the nose line as the nose in the set of map data; and/or identifying, in the three-dimensional map, at least one wall adjacent to the stairs, comprising determining a plurality of points of the point cloud associated with the at least one wall in the set of map data, fitting a one or more geometrical surfaces to the plurality of points associated with the at least one wall, and redefining the one or more geometrical surfaces as the at least one wall in the set of map data; and/or identifying, in the three-dimensional map, a railing structure adjacent to the stairs, comprising determining a plurality of points of the point cloud associated with a railing structure in the set of map data, fitting one or more geometrical surfaces to the plurality of points associated with the railing structure, and redefining the one or more geometrical surfaces as the railing structure in the set of map data, and identifying support interfaces on at least some of the steps and/or the at least one wall and/or the railing structure, based on design rules.

In the system, the projector, the detector, and the processor may be different or separate, yet interconnected devices communicatively coupled to each other. The processor may be a single processing device, or comprise a plurality of interconnected processing devices communicatively coupled to each other, wherein the plurality of processing devices may be physically located at different, even remote locations.

In some embodiments of the system, the one or more processors are configured for projecting onto said at least part of the structure a coherent random speckle pattern generated by a coherent light source and a light diffuser accommodated in the optical path of illuminating light propagating from the light source towards said at least part of the structure; detecting a light response from an illuminated region of said at least part of the structure; generating image data of said at least part of the structure with the projected speckle pattern; and processing the image data to determine a shift of the speckle pattern in the image of said at least part of the structure relative to a reference image of the speckle pattern, thereby determining the set of map data of said at least part of the structure.

In some embodiments of the system, the one or more processors further are configured for: generating a plurality of different sets of map data for overlapping different parts of the structure, optionally taken from different reference locations; and correlating the different sets of map data with each other to provide an extended set of map data representing a three-dimensional map of a combination of the different parts of the structure.

In some embodiments of the system, the one or more processors further are configured for: identifying, in the three-dimensional map, a series of steps of a stairs and/or at least one wall adjacent to the stairs and/or a railing structure adjacent to the stairs; and identifying support interfaces on at least some of the steps and/or the at least one wall and/or the railing structure, based on design rules.

In a third aspect of the invention, a computer program is provided. The computer program comprises computer instructions which, when loaded in a processor, cause the processor device to perform at least part of the method of embodiments of the invention.

These and other aspects of the invention will be more readily appreciated as the same becomes better understood by reference to the following detailed description and considered in connection with the accompanying drawings in which like reference symbols designate like parts.

### BRIEF DESCRIPTION OF THE DRAWINGS

Figure 1 depicts a perspective view of a staircase, and a schematic diagram of an embodiment of a system of the present invention
Figure 2 depicts a flow diagram of the method of the present invention.
Figure 3 depicts a flow diagram of an embodiment of part of the method of the present invention.
Figure 4 depicts a perspective view of a three-dimensional map of the staircase of Figure 1, as acquired by the system of the invention, and showing support interfaces for a stair lift rail assembly.

### DETAILED DESCRIPTION OF EMBODIMENTS

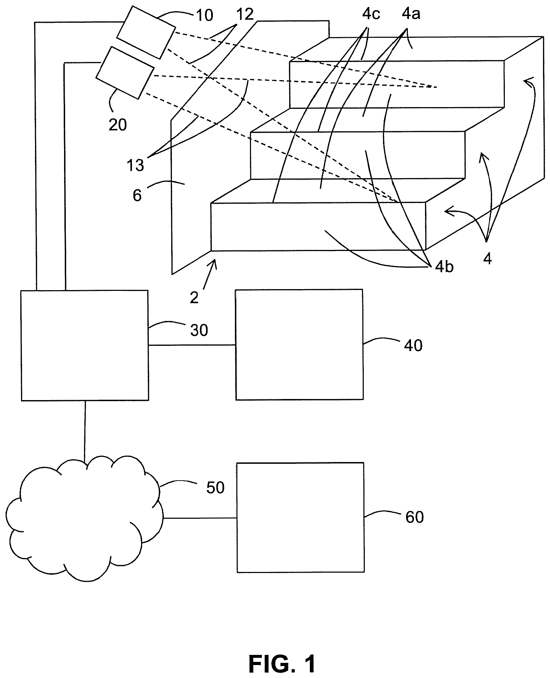

Figure 1 depicts a part of a staircase 2. The staircase comprises steps 4, each step having a top face 4a, a front face 4b, and a nose 4c. In Figure 1, only three steps 4 are shown. However, the staircase 2 can have less than three, or more than three steps 4. The staircase 2 may slope up along a straight line, as indicated in Figure 1. However, the staircase 2 may also slope up along a curved line. Different steps 4 may have equal or different widths and/or heights. Top faces 4a and/or front faces 4b of different steps 4 can have a rectangular shape as shown in Figure 1, or can have other shapes. In particular, a top face 4a can have a substantially trapezoidal shape, in particular when the width of consecutive steps 4 increases or decreases.

The staircase 2 may comprise a schematically indicated wall structure or railing structure 6 adjacent to the staircase 2. Other walls, floors, ceilings, and/or railing structures 6 may be present adjacent to the steps 4 of the staircase 2.

For the particular staircase 2, a stair lift needs to be designed. A stair lift generally comprises a stair lift rail assembly including a stair lift rail, a carrier movable along the stair lift rail, and control and drive devices to move the carrier along the stair lift rail.

The stair lift rail assembly is to be mounted relative to the staircase 2 such that an unimpeded movement of the carrier, including a person on the carrier, along the staircase 2 is possible. Preferably, a use of the staircase 2 by people not using the stair lift also is available. A stair lift rail assembly needs to be designed with these objects in mind, and should be fixed to the staircase 2 such that all forces acting on it during operation can be withstood.

To obtain a design of the stair lift rail assembly for a specific staircase 2, first of all the relevant dimensions of the staircase 2 and positions of parts thereof, including adjacent wall(s), floor(s), ceiling(s) and railing structure(s) 6, need to be determined. Once these dimensions have been determined, a spatial path for the stair lift rail can be determined, and support interfaces on the staircase 2 can be determined for mounting the stair lift rail assembly such that an optimum configuration of stair lift rail assembly and carrier for a flawless operation of the stair lift can be obtained, once the stair lift will have been installed.

As depicted in Figure 1, an optical measuring system, such as the system disclosed in WO 2007/043036 A1, is used to determine dimensions and positions of the staircase 2. The optical measuring system comprises a projector 10 and a detector 20. The projector 10 is configured for projecting, from a reference location relative to the staircase 2, a light beam 12 on at least part of the staircase 2. The light beam is indicated by a pair of diverging dashed lines originating from the projector 10. The detector 20 is configured for detecting light from at least part of the staircase 2 illuminated by the light beam 12 of the projector 10. The detected light from the staircase 2 to the detector 20 is indicated by a pair of converging dashed lines 13 originating from the staircase 2.

The projector 10 and the detector 20 may be mechanically connected. Both the projector 10 and the detector 20 are operatively connected, either wired or wirelessly, to a control device 30 for controlling the operation of projector 10 and detector 20. The control device 30 comprises, or is coupled to a processor 40 for processing data acquired by the detector 20. Data acquired by the detector 20 and/or data processed by the processor 40 may be transmitted, through a communication network 50, such as Internet or other private or public (tele)communication network, from the control device 30 to a further data processing device 60. The data processing device 60 includes at least one processor.

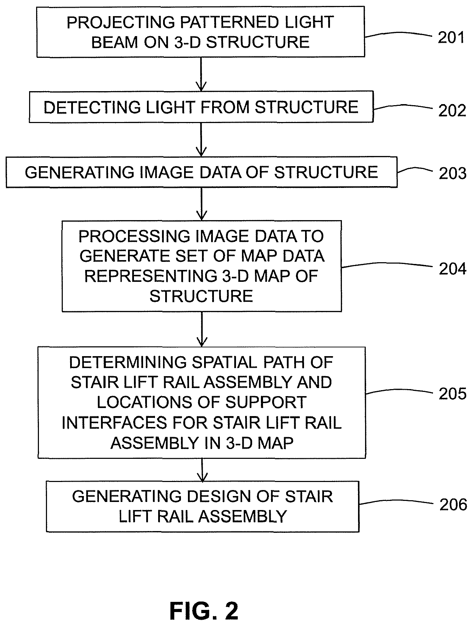

Referring to Figure 1, Figure 2 illustrates method steps of embodiments of a method of designing a stair lift rail assembly to be mounted on a three-dimensional structure, in particular a staircase 2.

According to step 201, the projector 10 projects, from a reference location relative to the staircase 2, a light beam 12 comprising an optical pattern on at least part of the staircase 2, which staircase 2 is also referred to as three-dimensional structure. The projection of patterned optical radiation, which may comprise visible light, IR light and/or UV light, from the projector 10 is controlled by the control device 30. Herein, a reference location is a location of the projector 10 and/or the detector 20, in particular a location of an imaging part thereof.

According to step 202, light from the at least part of the staircase 2 is detected by the detector 20, and data and/or signals representative of the detected light are transferred to the control device 30.

According to step 203, the processor 40 and/or the processing device 60, based on the data and/or signals received from the detector 20, generates image data of said at least part of the staircase 2.

According to step 204, the processor 40 and/or the processing device 60 processes/process the image data to generate a set of map data of said at least part of the staircase 2, the set of map data representing a three-dimensional map of said at least part of the staircase 2.

According to step 205, the processor 40 and/or the processing device 60 determines/determine a spatial path of the stair lift rail and locations of support interfaces for the stair lift rail assembly in the three-dimensional map. Herein, a support interface for the stair lift rail assembly is a part of the staircase 2, as represented in the three-dimensional map, on which a part of the stair lift rail assembly, such as an arm, leg or stanchion carrying a mounting structure like a wall support or flange, may be mounted.

According to step 206, the processor 40 and/or the processing device 60 generate a design of the stair lift rail assembly based on the spatial path of the stair lift rail and the locations of the support interfaces for the stair lift rail assembly. The design may include dimensions, bending radii, etc..

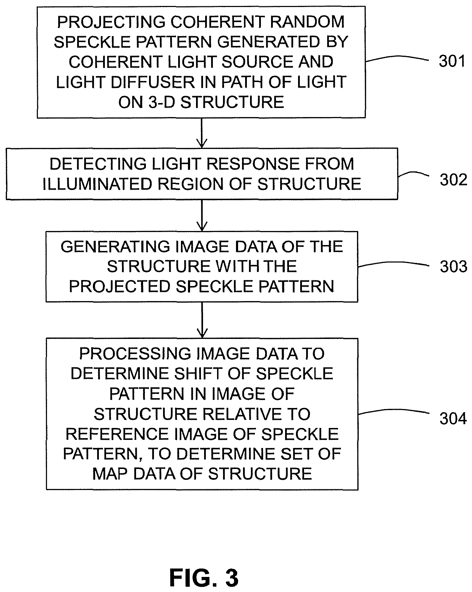

Figure 3 illustrates specific embodiments of steps 201-204, in steps 301-304, respectively, in line with the disclosure of WO 2007/043036 A1.

According to step 301, the step 201 of projecting a light beam, by projector 10, comprises projecting onto said at least part of the staircase 2 a coherent random speckle pattern generated by a coherent light source and a light diffuser accommodated in the optical path of illuminating light propagating from the light source towards said at least part of the staircase 2.

According to step 302, the step 202 of detecting light, by detector 20, comprises detecting a light response from an illuminated region of said at least part of the staircase 2.

According to step 303, the step 203 of generating image data, by processor 40 and/or processing device 60, comprises generating image data of said at least part of the staircase 2 with the projected speckle pattern.

According to step 304, the step 204 of processing the image data, by processor 40 and/or processing device 60, comprises processing the image data to determine a shift of the speckle pattern in the image of said at least part of the staircase 2 relative to a reference image of the speckle pattern, thereby determining the set of map data of said at least part of the staircase 2.

In an embodiment, the projector 10, detector 20, control device 30 and processor 40 may be an integrated, hand-held device, such as a portable computer, laptop type computer or tablet type computer. In a further embodiment, a general purpose hand-held device, such as a general purpose portable computer, laptop type computer or tablet type computer, may be coupled to the projector 10 and the detector 20 either by wire or wirelessly, where the projector 10 and the detector 20 may be mounted on or in the general purpose hand-held device or be separate therefrom. The projector 10 and detector 20 may be an integrated unit to ensure that the light detected by the detector 20 emanates from an area illuminated by patterned light projected by the projector 10. The dedicated or general-purpose hand-held device may comprise a communication module adapted and configured for data communication with communication network 50.

In practical environments, the projector 10 and/or the detector 20 sometimes cannot cover a complete staircase 2, e.g. when a line of sight from the detector does not cover part of the staircase 2. Thus, in such a case several different imaging actions need to be performed in order to collect different sets of map data to cover a complete staircase 2, by generating a plurality of different sets of map data for different, optionally overlapping, parts of the staircase 2, optionally taken from different reference locations. The different sets of map data are digitally correlated with each other in processor 30 and/or processing device 60 to provide an extended set of map data representing a three-dimensional map of a combination of the different parts of the staircase 2.

In step 205 above, the step of determining locations of support interfaces for the stair lift rail assembly in the three-dimensional map comprises identifying, by the processor 40 and/or the processing device 60, in the three-dimensional map, a series of steps of a stairs and/or at least one wall and/or a railing structure adjacent to the stairs. Once one or more of these structures have been recognized, support interfaces on at least some of the steps and/or the at least one wall and/or the railing structure can be projected, based on design rules. The design rules provide distances and positions to be kept, and may be implemented in software for automatically providing support interface locations.

In step 205 above, the step of identifying a series of steps 4 of a staircase 2 comprises identifying at least one of a top face 4a, a front face 4b, and a nose 4c of each step. Since a support interface may be on a top face 4a of a step 4, the locations of at least some of the top faces 4a needs to be determined. This can be done automatically by software loaded in the processor 40 or the processing device 60. In a method known per se from Liefeng Bo, Xiaofeng Ren, Dieter Fox. "Depth Kernel Descriptors for Object Recognition", Intelligent Robots and Systems (IROS), 2011 IEEE, the step of identifying a series of steps of a stairs and/or at least one wall adjacent to the stairs and/or a railing structure adjacent to the stairs may comprise analyzing image patches comprising image pixels having image pixel attributes, by measuring similarities of image patches based on said pixel attributes using kernel descriptors. A plurality of adjacent image patches thus can be recognized to represent a particular structure of a series of steps of a stairs and/or at least one wall adjacent to the stairs and/or a railing structure adjacent to the stairs.

In a user-driven embodiment of the method, support interfaces are not identified by software, but identified in an image of a three-dimensional map of the staircase 2 on a display, by a user. The user may position a pointer on a part of the model to indicate a location of a support interface. The pointer may be a mark or cross, movable across a displayed image of the model by a mouse or other input device. In case of a touch-screen display, the pointer may also be a touch device or a human finger having a tip to touch the display at a location showing the envisaged location of a support interface.

As the step of identifying a series of steps may comprise determining a plurality of points associated with a top face of the step in the set of map data, in order to remove quantization errors from the three-dimensional map of the staircase 2, a top plane may be fitted to the plurality of points associated with the top face, and the top plane is redefined as the top face in the set of map data. Similarly, for a front face, a front plane may be fitted to the plurality of points associated with the front face, and the front plane is redefined as the front face in the set of map data. Similarly, for a nose of a step, a nose line may be fitted to the plurality of points associated with the nose, and the nose line is redefined as the nose in the set of map data.

As the step of identifying a wall, floor or ceiling adjacent to the stairs may comprises determining a plurality of points associated with the wall, floor or ceiling in the set of map data, in order to remove quantization errors from the three-dimensional map of the staircase 2, one or more geometrical surfaces may be fitted to the plurality of points associated with the wall, floor or ceiling, and the one or more geometrical surfaces are redefined as the wall in the set of map data.

As the step of identifying a railing structure adjacent to the stairs may comprise determining a plurality of points associated with the railing structure in the set of map data, in order to remove quantization errors from the three-dimensional map of the staircase 2, one or more geometrical surfaces may be fitted to the plurality of points associated with the railing structure, and the one or more geometrical surfaces are redefined as the railing structure in the set of map data.

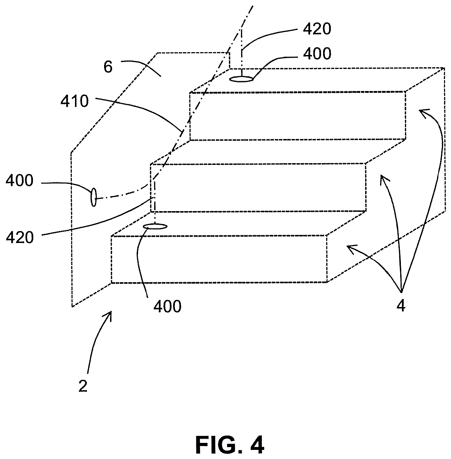

Figure 4 illustrates a three-dimensional map of the staircase 2 as obtained by projecting, by the projector 10, a light beam comprising an optical pattern on different parts of the staircase 2, detecting light, by the detector 20, from said different parts of the staircase 2, generating image data of said different parts of the staircase 2 based on said detected light, and processing the image data to generate a set of map data of said different parts of the staircase 2, the set of map data representing a three-dimensional map of said different parts of the staircase 2. The three-dimensional map is shown with dotted lines to indicate that the map is constituted by a point cloud. Based on the point cloud and the elements identified therein, such as a series of steps 4 and a wall or railing structure 6, (locations of) support interfaces 400 are determined by software or by a user, as explained above. The support interfaces 400 have such locations that a stair lift rail assembly having a stair lift rail following a spatial path 410 can be fixed and supported, such as by stanchions following spatial paths 420, to withstand all forces exerted thereon in operation, e.g. when a carrier mounted on the stair lift rail assembly receives a person, and conveys the person along the staircase 2.

An actual design of the stair lift rail assembly, which can be the basis of a technical specification, such as a technical drawing, for the manufacture of a stair lift rail assembly, can be made based on the locations of the support interfaces 400 and the spatial paths 410, 420.

As explained above, in a method and system of designing a stair lift rail assembly to be mounted on a three-dimensional structure, a light beam comprising an optical pattern on at least part of the structure is projected from a reference location relative to the structure. Light from said structure is detected. Image data of said structure are generated based on said detected light. The image data are processed to generate a set of map data of said structure, the set of map data representing a three-dimensional map of said structure. A spatial path of the stair lift rail and locations of support interfaces for the stair lift rail assembly in the three-dimensional map are determined. A design of the stair lift rail assembly is generated based on the spatial path of the stair lift rail and the locations of the support interfaces for the stair lift rail assembly.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting, but rather, to provide an understandable description of the invention.

The term "a"/"an", as used herein, is defined as one or more than one. The term plurality, as used herein, is defined as two or more than two. The term another, as used herein, is defined as at least a second or more. The terms including and/or having, as used herein, are defined as comprising (i.e., open language, not excluding other elements or steps). Any reference signs in the claims should not be construed as limiting the scope of the claims or the invention.

The mere fact that certain measures are recited in mutually different dependent claims does not indicate that a combination of these measures cannot be used to advantage.

The term coupled, as used herein, is defined as connected, although not necessarily directly, and not necessarily mechanically.

A single processor, processing unit, or other unit may fulfil the functions of several items recited in the claims.

The terms computer program, software application, and the like as used herein, are defined as a sequence of instructions designed for execution on a computer system. A program, computer program, or software application may include a subroutine, a function, a procedure, an object method, an object implementation, an executable application, an applet, a servlet, a source code, an object code, a shared library/dynamic load library and/or other sequence of instructions designed for execution on a computer system.

A computer program may be stored and/or distributed on a suitable medium, such as an optical storage medium or a solid-state medium supplied together with or as part of other hardware, but also be distributed in other forms, such as through signals via the Internet or other wired or wireless telecommunication systems.

## Claims

1. A method of designing a stair lift rail assembly to be mounted on a three-dimensional structure (2), the method comprising the steps of:
projecting (201), from a reference location relative to the structure, a light beam (12) comprising an optical pattern on at least part of the structure (2);
detecting (202) light from said at least part of the structure (2);
generating (203) image data of said at least part of the structure based on said detected light;
processing (204) the image data to generate a set of map data of said at least part of the structure, the set of map data being a point cloud representing a three-dimensional map of said at least part of the structure;
determining (205) a spatial path of the stair lift rail and locations of support interfaces for the stair lift rail assembly in the three-dimensional map; and
generating (206) a design of the stair lift rail assembly based on the spatial path of the stair lift rail and the locations of the support interfaces for the stair lift rail assembly,
wherein the step of determining locations of support interfaces for the stair lift rail assembly in the three-dimensional map comprises:
identifying, in the three-dimensional map, a series of steps of a stairs, comprising determining a plurality of points of the point cloud associated with a top face (4a) of the step (4) in the set of map data, fitting a top plane to the plurality of points associated with the top face, and redefining the top plane as the top face in the set of map data; and/or
identifying, in the three-dimensional map, a series of steps of a stairs, comprising determining a plurality of points of the point cloud associated with a front face (4b) of the step (4) in the set of map data, fitting a front plane to the plurality of points associated with the front face, and redefining the front plane as the front face in the set of map data; and/or
identifying, in the three-dimensional map, a series of steps of a stairs, comprising determining a plurality of points of the point cloud associated with a nose (4c) of the step (4) in the set of map data, fitting a nose line to the plurality of points associated with the nose, and redefining the nose line as the nose in the set of map data; and/or
identifying, in the three-dimensional map, at least a wall, floor or ceiling adjacent to the stairs, comprising determining a plurality of points of the point cloud associated with a wall, floor or ceiling in the set of map data, fitting a one or more geometrical surfaces to the plurality of points associated with the wall, floor or ceiling, and redefining the one or more geometrical surfaces as the wall, floor or ceiling in the set of map data; and/or
identifying, in the three-dimensional map, a railing structure (6) adjacent to the stairs, comprising determining a plurality of points of the point cloud associated with a railing structure in the set of map data, fitting one or more geometrical surfaces to the plurality of points associated with the railing structure, and redefining the one or more geometrical surfaces as the railing structure in the set of map data, and
identifying support interfaces on at least some of the steps and/or the at least one wall, floor, or ceiling and/or the railing structure, based on design rules.

2. The method according to claim 1,
wherein the step of projecting a light beam (12) comprises projecting (301) onto said at least part of the structure a coherent random speckle pattern generated by a coherent light source and a light diffuser accommodated in the optical path of illuminating light propagating from the light source towards said at least part of the structure;
wherein the step of detecting light comprises detecting (302) a light response from an illuminated region of said at least part of the structure;
wherein the step of generating image data comprises generating (303) image data of said at least part of the structure with the projected speckle pattern; and
wherein the step of processing the image data comprises processing (304) the image data to determine a shift of the speckle pattern in the image of said at least part of the structure relative to a reference image of the speckle pattern, thereby determining the set of map data of said at least part of the structure.

3. The method according to claim 1 or 2, further comprising:
generating a plurality of different sets of map data for different, optionally overlapping, parts of the structure, optionally taken from different reference locations; and
correlating the different sets of map data with each other to provide an extended set of map data representing a three-dimensional map of a combination of the different parts of the structure.

4. The method according to any of the preceding claims, wherein the step of identifying a series of steps of a stairs and/or at least one wall adjacent to the stairs and/or a railing structure adjacent to the stairs comprises:
analyzing image patches comprising image pixels having image pixel attributes, by measuring similarities of image patches based on said pixel attributes using kernel descriptors.

5. The method according to any of the preceding claims, further comprising:
displaying a model of the three-dimensional structure on a display; and
identifying, by a user, in the model at least one support interface.

6. A system for designing a stair lift rail assembly to be mounted on a three-dimensional structure (2), the system comprising:
a projector (10) configured for projecting, from a reference location relative to the structure, a light beam (12) comprising an optical pattern on at least part of the structure;
a detector (20) configured for detecting light from said at least part of the structure; and
one or more processors (40) configured for:
- generating (203) image data of said at least part of the structure based on said detected light;
- processing (204) the image data to generate a set of map data of said at least part of the structure, the set of map data being a point cloud representing a three-dimensional map of said at least part of the structure;
- determining (205) a spatial path of the stair lift rail and locations of support interfaces for the stair lift rail assembly in the three-dimensional map; and
- generating (206) a design of the stair lift rail assembly based on the spatial path of the stair lift rail and the locations of the support interfaces for the stair lift rail assembly,
wherein the one or more processors are configured for determining locations of support interfaces for the stair lift rail assembly in the three-dimensional map by:
identifying, in the three-dimensional map, a series of steps of a stairs, comprising determining a plurality of points of the point cloud associated with a top face (4a) of the step in the set of map data, fitting a top plane to the plurality of points associated with the top face, and redefining the top plane as the top face in the set of map data; and/or
identifying, in the three-dimensional map, a series of steps of a stairs, comprising determining a plurality of points of the point cloud associated with a front face (4b) of the step in the set of map data, fitting a front plane to the plurality of points associated with the front face, and redefining the front plane as the front face in the set of map data; and/or
identifying, in the three-dimensional map, a series of steps of a stairs, comprising determining a plurality of points of the point cloud associated with a nose (4c) of the step in the set of map data, fitting a nose line to the plurality of points associated with the nose, and redefining the nose line as the nose in the set of map data; and/or
identifying, in the three-dimensional map, at least one wall adjacent to the stairs, comprising determining a plurality of points of the point cloud associated with the at least one wall in the set of map data, fitting a one or more geometrical surfaces to the plurality of points associated with the at least one wall, and redefining the one or more geometrical surfaces as the at least one wall in the set of map data; and/or
identifying, in the three-dimensional map, a railing structure (6) adjacent to the stairs, comprising determining a plurality of points of the point cloud associated with a railing structure in the set of map data, fitting one or more geometrical surfaces to the plurality of points associated with the railing structure, and redefining the one or more geometrical surfaces as the railing structure in the set of map data, and
identifying support interfaces on at least some of the steps and/or the at least one wall and/or the railing structure, based on design rules.

7. The system according to claim 6, wherein the one or more processors (40) are configured for:
projecting (301) onto said at least part of the structure a coherent random speckle pattern generated by a coherent light source and a light diffuser accommodated in the optical path of illuminating light propagating from the light source towards said at least part of the structure;
detecting (302) a light response from an illuminated region of said at least part of the structure;
generating (303) image data of said at least part of the structure with the projected speckle pattern; and
processing (304) the image data to determine a shift of the speckle pattern in the image of said at least part of the structure relative to a reference image of the speckle pattern, thereby determining the set of map data of said at least part of the structure.

8. The system of claim 6 or 7, wherein the one or more processors further are configured for:
generating a plurality of different sets of map data for overlapping different parts of the structure, optionally taken from different reference locations; and
correlating the different sets of map data with each other to provide an extended set of map data representing a three-dimensional map of a combination of the different parts of the structure.

9. A computer program comprising computer instructions which, when loaded in a processor (40), cause the processor to perform the method of any of claims 1 to 5.

## Patentansprüche

1. Verfahren zum Gestalten von einer Treppenliftschienenanordnung zur Befestigung an einer dreidimensionalen Struktur (2), wobei das Verfahren die folgenden Schritte umfasst:
Projizieren (201), von einem Bezugsort relativ zu der Struktur, von einem Lichtstrahl (12), der ein optisches Muster umfasst, auf mindestens einen Teil der Struktur (2);
Detektieren (202) von Licht von dem mindestens einen Teil der Struktur (2);
Erzeugen (203) von Bilddaten des mindestens einen Teils der Struktur auf Basis von dem detektierten Licht;
Verarbeiten (204) von den Bilddaten, um einen Satz an Kartendaten des mindestens einen Teils der Struktur zu erzeugen, wobei der Satz an Kartendaten eine Punktwolke ist, die eine dreidimensionale Karte des mindestens einen Teils der Struktur repräsentiert;
Bestimmen (205) von einem räumlichen Weg der Treppenliftschiene und von Orten für Trägerverbindungen für die Treppenliftschienenanordnung in der dreidimensionalen Karte;
Erzeugen (206) von einer Gestaltung der Treppenliftschienenanordnung auf Basis von dem räumlichen Weg der Treppenschriftschiene und den Orten für die Trägerverbindungen für die Treppenliftschienenanordnung,
wobei der Schritt des Bestimmens von Orten von Trägerverbindungen für die Treppenliftschienenanordnung in der dreidimensionalen Karte das Folgende umfasst:
Identifizieren, in der dreidimensionalen Karte, von einer Reihe von Stufen von einer Treppe, umfassend das Bestimmen von einer Vielzahl von Punkten von der Punktwolke, die mit einer oberen Seite (4a) der Stufe (4) in dem Satz von Kartendaten assoziiert sind, Anpassen von einer oberen Ebene zu der Vielzahl von Punkten, die mit der oberen Seite assoziiert sind, und Neudefinieren von der oberen Ebene als die obere Seite in dem Satz von Kartendaten; und/oder
Identifizieren, in der dreidimensionalen Karte, von einer Reihe von Stufen von einer Treppe, umfassend das Bestimmen von einer Vielzahl von Punkten von der Punktwolke, die mit einer vorderen Seite (4b) der Stufe (4) in dem Satz von Kartendaten assoziiert sind, Anpassen von einer vorderen Ebene zu der Vielzahl von Punkten, die mit der vorderen Seite assoziiert sind, und Neudefinieren von der vorderen Ebene als die vordere Seite in dem Satz von Kartendaten; und/oder
Identifizieren, in der dreidimensionalen Karte, von einer Reihe von Stufen von einer Treppe, umfassend das Bestimmen von einer Vielzahl von Punkten von der Punktwolke, die mit einer Stufenkante (4c) der Stufe (4) in dem Satz von Kartendaten assoziiert sind, Anpassen von einer Stufenkantenlinie zu der Vielzahl von Punkten, die mit der Stufenkante assoziiert sind, und Neudefinieren von der Stufenkantenlinie als die Stufenkante in dem Satz von Kartendaten; und/oder
Identifizieren, in der dreidimensionalen Karte, von mindestens einer Wand, einem Boden oder einer Decke, angrenzend an die Treppe, umfassend das Bestimmen von einer Vielzahl von Punkten von der Punktwolke, die mit einer Wand, einem Boden oder einer Decke in dem Satz von Kartendaten assoziiert sind, Anpassen von einer oder mehreren geometrischen Oberflächen zu der Vielzahl von Punkten, die mit der Wand, dem Boden oder der Decke assoziiert sind, und Neudefinieren von den einen oder mehreren geometrischen Oberflächen als die Wand, den Boden oder die Decke in dem Satz von Kartendaten; und/oder
Identifizieren, in der dreidimensionalen Karte, von einer Geländerstruktur (6), angrenzend an die Treppe, umfassend das Bestimmen von einer Vielzahl von Punkten von der Punktwolke, die mit einer Geländerstruktur in dem Satz von Kartendaten assoziiert sind, Anpassen von einer oder mehreren geometrischen Oberflächen zu der Vielzahl von Punkten, die mit der Geländerstruktur assoziiert sind, und Neudefinieren von den einen oder mehreren geometrischen Oberflächen als die Geländerstruktur in dem Satz von Kartendaten, und
Identifizieren von Trägerverbindungen auf zumindest manchen der Stufen und/oder der mindestens einen Wand, einem Boden oder einen Decke und/oder der Geländerstruktur, und zwar auf Basis der Gestaltungsregeln.

2. Verfahren nach Anspruch 1,
wobei der Schritt des Projizierens von einem Lichtstrahl (12) das Projizieren (301) auf den mindestens einen Teil der Struktur von einem kohärenten zufälligen Fleckenmuster, das durch eine kohärente Lichtquelle und einen Lichtzerstreuer, der in dem optischen Weg des Beleuchtungslichts untergebracht ist, erzeugt wird, das sich von der Lichtquelle in Richtung des mindestens einen Teils der Struktur ausbreitet;
wobei der Schritt des Detektierens von Licht das Detektieren (302) von einer Lichtantwort von einer beleuchteten Region des mindestens einen Teils der Struktur umfasst;
wobei der Schritt des Erzeugens von Bilddaten das Erzeugen (303) von Bilddaten von dem mindestens einen Teil der Struktur mit dem projizierten Fleckenmuster umfasst; und
wobei der Schritt des Verarbeitens von den Bilddaten das Verarbeiten (304) der Bilddaten umfasst, um eine Verlagerung des Fleckenmusters in dem Bild von dem mindestens einen Teil der Struktur relativ zu einem Bezugsbild des Fleckenmusters zu bestimmen, wodurch der Satz an Kartendaten des mindestens einen Teils der Struktur bestimmt wird.

3. Verfahren nach Anspruch 1 oder 2, ferner umfassend:
das Erzeugen von einer Vielzahl verschiedener Sätze an Kartendaten für unterschiedliche, optional überlappende, Teile der Struktur, die optional von verschiedenen Bezugsorten aufgenommen werden; und
Korrelieren von den verschiedenen Sätzen an Kartendaten miteinander, um einen erweiterten Satz an Kartendaten bereitzustellen, der eine dreidimensionale Karte von einer Kombination aus den verschiedenen Teilen der Struktur repräsentiert.

4. Verfahren nach einem der vorhergehenden Ansprüche, wobei der Schritt des Identifizieren von einer Reihe von Stufen von einer Treppe und/oder mindestens einer Wand, angrenzend an die Treppe, und/oder einer Geländerstruktur, angrenzend an die Treppe, das Folgende umfasst:
Analysieren von Bildfenstern, die Bildpixel umfassen, die Bildpixeleigenschaften aufweisen, durch Messen von Ähnlichkeiten der Bildfenster auf Basis der Pixeleigenschaften unter Verwendung von Kernel-Deskriptoren.

5. Verfahren nach einem der vorhergehenden Ansprüche, ferner umfassend:
Darstellen von einem Modell der dreidimensionalen Struktur auf einem Display; und
Identifizieren, durch einen Benutzer, in dem Modell von mindestens einer Trägerverbindung.

6. System zum Gestalten von einem Treppenliftschienenanordnung zur Befestigung an einer dreidimensionalen Struktur (2), wobei das System das Folgende umfasst:
einen Projektor (10), der konfiguriert ist, um von einem Bezugsort relativ zu der Struktur einen Lichtstrahl (12), der ein optisches Muster umfasst, auf mindestens einen Teil der Struktur zu projizieren;
einen Detektor (20), der konfiguriert ist, um Licht von dem mindestens einen Teil der Struktur zu detektieren; und
eine oder mehrere Verarbeitungseinheiten (40), die für das Folgende konfiguriert sind:
- Erzeugen (203) von Bilddaten des mindestens einen Teils der Struktur auf Basis von dem detektierten Licht;
- Verarbeiten (204) von den Bilddaten, um einen Satz an Kartendaten des mindestens einen Teils der Struktur zu erzeugen, wobei der Satz an Kartendaten eine Punktwolke ist, die eine dreidimensionale Karte des mindestens einen Teils der Struktur repräsentiert;
- Bestimmen (205) von einem räumlichen Weg der Treppenliftschiene und von Orten für Trägerverbindungen für die Treppenliftschienenanordnung in der dreidimensionalen Karte; und
- Erzeugen (206) von einer Gestaltung der Treppenliftschienenanordnung auf Basis von dem räumlichen Weg der Treppenschriftschiene und den Orten für die Trägerverbindungen für die Treppenliftschienenanordnung,
wobei die einen oder mehreren Verarbeitungseinheiten konfiguriert sind, um Orte von Trägerverbindungen für die Treppenliftschienenanordnung in der dreidimensionalen Karte durch das Folgende zu bestimmen:
Identifizieren, in der dreidimensionalen Karte, von einer Reihe von Stufen von einer Treppe, umfassend das Bestimmen von einer Vielzahl von Punkten von der Punktwolke, die mit einer oberen Seite (4a) der Stufe in dem Satz von Kartendaten assoziiert sind, Anpassen von einer oberen Ebene zu der Vielzahl von Punkten, die mit der oberen Seite assoziiert sind, und Neudefinieren von der oberen Ebene als die obere Seite in dem Satz von Kartendaten; und/oder
Identifizieren, in der dreidimensionalen Karte, von einer Reihe von Stufen von einer Treppe, umfassend das Bestimmen von einer Vielzahl von Punkten von der Punktwolke, die mit einer vorderen Seite (4b) der Stufe in dem Satz von Kartendaten assoziiert sind, Anpassen von einer vorderen Ebene zu der Vielzahl von Punkten, die mit der vorderen Seite assoziiert sind, und Neudefinieren von der vorderen Ebene als die vordere Seite in dem Satz von Kartendaten; und/oder
Identifizieren, in der dreidimensionalen Karte, von einer Reihe von Stufen von einer Treppe, umfassend das Bestimmen von einer Vielzahl von Punkten von der Punktwolke, die mit einer Stufenkante (4c) der Stufe in dem Satz von Kartendaten assoziiert sind, Anpassen von einer Stufenkantenlinie zu der Vielzahl von Punkten, die mit der Stufenkante assoziiert sind, und Neudefinieren von der Stufenkantenlinie als die Stufenkante in dem Satz von Kartendaten; und/oder
Identifizieren, in der dreidimensionalen Karte, von mindestens einer Wand, angrenzend an die Treppe, umfassend das Bestimmen von einer Vielzahl von Punkten von der Punktwolke, die mit der mindesten einen Wand in dem Satz von Kartendaten assoziiert sind, Anpassen von einer oder mehreren geometrischen Oberflächen zu der Vielzahl von Punkten, die mit der Wand assoziiert sind, und Neudefinieren von den einen oder mehreren geometrischen Oberflächen als die mindestens eine Wand in dem Satz von Kartendaten; und/oder
Identifizieren, in der dreidimensionalen Karte, von einer Geländerstruktur (6), angrenzend an die Treppe, umfassend das Bestimmen von einer Vielzahl von Punkten von der Punktwolke, die mit einer Geländerstruktur in dem Satz von Kartendaten assoziiert sind, Anpassen von einer oder mehreren geometrischen Oberflächen zu der Vielzahl von Punkten, die mit der Geländerstruktur assoziiert sind, und Neudefinieren von den einen oder mehreren geometrischen Oberflächen als die Geländerstruktur in dem Satz von Kartendaten, und
Identifizieren von Trägerverbindungen auf zumindest manchen der Stufen und/oder der mindestens einen Wand und/oder der Geländerstruktur, und zwar auf Basis der Gestaltungsregeln.

7. System nach Anspruch 6, wobei die einen oder mehreren Verarbeitungseinheiten (40) für das Folgende konfiguriert sind:
Projizieren (301) auf den mindestens einen Teil der Struktur von einem kohärenten zufälligen Fleckenmuster, das durch eine kohärente Lichtquelle und einen Lichtzerstreuer, der in dem optischen Weg des Beleuchtungslichts untergebracht ist, erzeugt wird, das sich von der Lichtquelle in Richtung des mindestens einen Teils der Struktur ausbreitet;
Detektieren (302) von einer Lichtantwort von einer beleuchteten Region des mindestens einen Teils der Struktur;
Erzeugen (303) von Bilddaten von dem mindestens einen Teil der Struktur mit dem projizierten Fleckenmuster; und
Verarbeiten (304) der Bilddaten, um eine Verlagerung des Fleckenmusters in dem Bild von dem mindestens einen Teil der Struktur relativ zu einem Bezugsbild des Fleckenmusters zu bestimmen, wodurch der Satz an Kartendaten des mindestens einen Teils der Struktur bestimmt wird.

8. System nach Anspruch 6 oder 7, wobei die einen oder mehreren Verarbeitungseinheiten ferner für das Folgende konfiguriert sind:
Erzeugen von einer Vielzahl verschiedener Sätze an Kartendaten für überlappende unterschiedliche Teile der Struktur, die optional von verschiedenen Bezugsorten aufgenommen werden; und
Korrelieren von den verschiedenen Sätzen an Kartendaten miteinander, um einen erweiterten Satz an Kartendaten bereitzustellen, der eine dreidimensionale Karte von einer Kombination aus den verschiedenen Teilen der Struktur repräsentiert.

9. Computerprogramm, umfassen Computerinstruktionen, die, wenn sie in eine Verarbeitungseinheit (40) geladen werden die Verarbeitungseinheit veranlassen, das Verfahren nach einem der Ansprüche 1 bis 5 durchzuführen.

## Revendications

1. Procédé de conception d'un ensemble rail de monte-escalier destiné à être monté sur une structure (2) tridimensionnelle, le procédé comprenant les étapes de:
projeter (201), à partir d'un emplacement de référence par rapport à la structure, un faisceau lumineux (12) comprenant un motif optique sur au moins une partie de la structure (2);
détecter (202) de la lumière provenant de ladite au moins une partie de la structure (2);
générer (203) des données d'image de ladite au moins une partie de la structure sur la base de ladite lumière détectée;
traiter (204) les données d'image pour générer un ensemble de données cartographiques de ladite au moins une partie de la structure, l'ensemble de données cartographiques étant un nuage de points représentant une carte tridimensionnelle de ladite au moins une partie de la structure;
déterminer (205) une trajectoire spatiale du rail de monte-escalier et des emplacements d'interfaces de support pour l'ensemble rail de monte-escalier dans la carte tridimensionnelle; et
générer (206) une conception de l'ensemble rail de monte-escalier sur la base du chemin dans l'espace du rail de monte-escalier et des emplacements d'interfaces de support pour l'ensemble rail de monte-escalier,
dans lequel l'étape de détermination des emplacements d'interfaces de support pour l'ensemble rail de monte-escalier dans la carte tridimensionnelle comprend les étapes de :
identifier, dans la carte tridimensionnelle, une série de marches d'escalier, comprenant la détermination d'une pluralité de points du nuage de points associés à une face supérieure (4a) de la marche (4) dans l'ensemble de données cartographiques, l'ajustement d'un plan supérieur à la pluralité de points associés à la face supérieure, et la redéfinition du plan supérieur comme la face supérieure dans l'ensemble de données cartographiques ; et/ou
identifier, dans la carte tridimensionnelle, une série de marches d'escalier, comprenant la détermination d'une pluralité de points du nuage de points associés à une face avant (4b) de la marche (4) dans l'ensemble de données cartographiques, l'ajustement d'un plan avant à la pluralité de points associés à la face avant, et la redéfinition du plan avant comme la face avant dans l'ensemble de données cartographiques ; et/ou
identifier, dans la carte tridimensionnelle, une série de marches d'escalier, comprenant la détermination d'une pluralité de points du nuage de points associés à un nez (4c) de la marche (4) dans l'ensemble de données cartographiques, l'ajustement d'une ligne de nez à la pluralité de points associés au nez, et la redéfinition de la ligne de nez comme le nez dans l'ensemble de données cartographiques ; et/ou
identifier, dans la carte tridimensionnelle, au moins un mur, sol ou plafond adjacent aux escaliers, comprenant la détermination d'une pluralité de points du nuage de points associés à un mur, sol ou plafond dans l'ensemble de données cartographiques, l'ajustement d'une ou plusieurs surfaces géométriques à la pluralité de points associée au mur, sol ou plafond, et la redéfinition de la une ou plusieurs surfaces géométriques comme le mur, sol ou plafond dans l'ensemble de données cartographiques ; et/ou
identifier, dans la carte tridimensionnelle, une structure de rampe (6) adjacente aux escalier, comprenant la détermination d'une pluralité de points du nuages de points associés à une structure de rampe dans l'ensemble de données cartographiques, l'ajustement d'une ou plusieurs surfaces géométriques à la pluralité de points associée à la structure de rampe, et la redéfinition de la une ou plusieurs surfaces géométriques comme la structure de rampe dans l'ensemble de données cartographiques, et
identifier des interfaces de support sur au moins certaines des marches et/ou du au moins un mur, sol ou plancher et/ou de la structure de rampe, sur la base de règles de conception.

2. Le procédé selon la revendication 1,
dans lequel l'étape de projection d'un faisceau lumineux (12) comprend une étape de projection (301), sur ladite au moins une partie de la structure, d'un motif de tâches aléatoire cohérent généré par une source de lumière cohérente et un diffuseur de lumière logé sur le chemin optique de lumière d'illumination se propageant de la source de lumière vers ladite au moins une partie de la structure;
dans lequel l'étape de détection de lumière comprend une étape de détection (302) d'une réponse lumineuse d'une région illuminée de ladite au moins une partie de la structure;
dans lequel l'étape de génération de données d'image comprend l'étape de générer (303) des données d'image de ladite au moins une partie de la structure avec le motif de tâches projeté; et
dans lequel l'étape de traitement des données d'image comprend une étape de traiter (304) les données d'image pour déterminer un décalage du motif de tâches dans l'image de ladite au moins une partie de la structure par rapport à une image de référence du motif de tâches, déterminant ainsi l'ensemble de données cartographiques de ladite au moins une partie de la structure.

3. Le procédé selon la revendication 1 ou 2, comprenant en outre les étapes de :
générer une pluralité d'ensembles différents de données cartographiques pour différentes parties de la structure, éventuellement se chevauchant, éventuellement pris à partir de différents emplacements de référence; et
corréler les différents ensembles de données cartographiques entre eux pour fournir un ensemble étendu de données cartographiques représentant une carte tridimensionnelle d'une combinaison des différentes parties de la structure.

4. Le procédé selon l'une quelconque des revendications précédentes, dans lequel l'identification d'une série de marches d'escalier et/ou d'au moins un mur adjacent aux escaliers et/ou d'une structure de rampe adjacente aux escaliers comprend l'étape de :
analyser des bouts d'image comprenant des pixels d'image ayant des attributs de pixel en mesurant des similarités de bouts d'image sur la base desdits attributs de pixel en utilisant un descripteur de noyau.

5. Le procédé selon l'une quelconque des revendications précédentes, comprenant en outre les étapes de :
afficher un modèle de la structure tridimensionnelle sur un écran ; et
faire identifier par un utilisateur au moins une interface de support dans le modèle.

6. Un système pour concevoir un ensemble rail de monte-escalier destiné à être monté sur une structure (2) tridimensionnelle, le système comprenant:
un projecteur (10) configuré pour projeter, à partir d'un emplacement de référence par rapport à la structure, un faisceau lumineux (12) comprenant un motif optique sur au moins une partie la structure;
un détecteur (20) configuré pour détecter de la lumière provenant de ladite au moins une partie de la structure; et
un ou plusieurs processeurs (40) configurés pour:
- générer (203) des données d'image de ladite au moins une partie de la structure sur la base de ladite lumière détectée;
- traiter (204) les données d'image pour générer un ensemble de données cartographiques de ladite au moins une partie de la structure, l'ensemble de données cartographiques étant un nuage de points représentant une carte tridimensionnelle de ladite au moins une partie de la structure;
- déterminer (205) une trajectoire spatiale du rail de monte-escalier et des emplacements des interfaces de support pour l'ensemble rail de monte-escalier dans la carte tridimensionnelle; et
- générer (206) une conception de l'ensemble rail de monte-escalier sur la base du chemin dans l'espace du rail de monte-escalier et des emplacements des interfaces de support pour l'ensemble rail de monte-escalier,
dans lequel le ou les plusieurs processeurs sont configurés pour déterminer des emplacements d'interfaces de support pour l'ensemble rail de monte-escalier dans la carte tridimensionnelle en :
identifiant, dans la carte tridimensionnelle, une série de marches d'escalier, ce qui comprend la détermination d'une pluralité de points du nuage de points associés à une face supérieure (4a) de la marche dans l'ensemble de données cartographiques, l'ajustement d'un plan supérieur à la pluralité de points associés à la face supérieure, et la redéfinition du plan supérieur comme la face supérieure dans l'ensemble de données cartographiques ; et/ou
identifiant, dans la carte tridimensionnelle, une série de marches d'escalier, ce qui comprend la détermination d'une pluralité de points du nuage de points associés à une face avant (4b) de la marche dans l'ensemble de données cartographiques, l'ajustement d'un plan avant à la pluralité de points associés à la face avant, et la redéfinition du plan avant comme la face avant dans l'ensemble de données cartographiques ; et/ou
identifiant, dans la carte tridimensionnelle, une série de marches d'escalier, ce qui comprend la détermination d'une pluralité de points du nuage de points associés à un nez (4c) de la marche dans l'ensemble de données cartographiques, l'ajustement d'une ligne de nez à la pluralité de points associés au nez, et la redéfinition de la ligne de nez comme le nez dans l'ensemble de données cartographiques ; et/ou
identifiant, dans la carte tridimensionnelle, au moins un mur adjacent aux escaliers, ce qui comprend la détermination d'une pluralité de points du nuage de points associés à au moins un mur dans l'ensemble de données cartographiques, l'ajustement d'une ou plusieurs surfaces géométriques à la pluralité de points associée au moins au mur et la redéfinition de la une ou plusieurs surfaces géométriques comme au moins le mur dans l'ensemble de données cartographiques ; et/ou
identifiant, dans la carte tridimensionnelle, une structure de rampe (6) adjacente aux escaliers, ce qui comprend la détermination d'une pluralité de points du nuages de points associés à une structure de rampe dans l'ensemble de données cartographiques, l'ajustement d'une ou plusieurs surfaces géométriques à la pluralité de points associée à la structure de rampe, et la redéfinition de la une ou plusieurs surfaces géométriques comme la structure de rampe dans l'ensemble de données cartographiques, et en
identifiant des interfaces de support sur au moins certains des marches et/ou du au moins un mur et/ou de la structure de rampe, sur la base de règles de conception.

7. Le système selon la revendication 6, dans lequel le ou les processeurs (40) sont configurés pour:
projeter (301) sur ladite au moins une partie de la structure un motif de tâches aléatoire cohérent généré par une source de lumière cohérente et un diffuseur de lumière logé sur le chemin optique de lumière d'illumination se propageant de la source de lumière vers ladite au moins une partie de la structure;
détecter (302) une réponse lumineuse d'une région illuminée de ladite au moins une partie de la structure;
générer (303) des données d'image de ladite au moins une partie de la structure avec le motif de tâches projeté; et
traiter (304) les données d'image pour déterminer un décalage du motif de tâches dans l'image de ladite au moins une partie de la structure par rapport à une image de référence du motif de tâches, déterminant ainsi l'ensemble de données cartographiques de ladite au moins une partie de la structure.

8. Le système des revendication 6 ou 7, dans lequel le ou les processeurs sont en outre configurés pour:
générer une pluralité d'ensembles différents de données cartographiques pour faire se chevaucher différentes parties de la structure, éventuellement pris à partir de différents emplacements de référence; et
corréler les différents ensembles de données cartographiques entre eux pour fournir un ensemble étendu de données cartographiques représentant une carte tridimensionnelle d'une combinaison des différentes parties de la structure.

9. Un programme informatique comprenant des instructions informatiques qui, lorsqu'elles sont chargées dans un processeur (40), amènent le processeur à exécuter le procédé de l'une quelconque des revendications 1 à 5.
